**Europäisches Patentamt**

**European Patent Office**

**Office européen des brevets**

(11) Numéro de publication: **0 064 780**

**A1**

(12)

# DEMANDE DE BREVET EUROPEEN

(21) Numéro de dépôt: **82200439.6**

(22) Date de dépôt: **13.04.82**

(51) Int. Cl.³: **A 44 C 17/00**
**G 03 F 7/26**
**//C30B33/00, C23C15/00**

(30) Priorité: **07.05.81 BE 204718**

(43) Date de publication de la demande:
**17.11.82 Bulletin 82/46**

(84) Etats contractants désignés:
**CH DE FR GB IT LI LU NL**

(71) Demandeur: **Hakoune, Maurice**
**Belgielei 147**
**B-2000 Antwerpen(BE)**

(72) Inventeur: **Hakoune, Maurice**
**Belgielei 147**
**B-2000 Antwerpen(BE)**

(74) Mandataire: **Pieraerts, Jacques et al,**
**Bureau Gevers S.A. rue de Livourne 7, Bte. 1**
**B-1050 Bruxelles(BE)**

(54) Procédé de traitement d'une pierre précieuse et pierre précieuse ainsi traitée.

(57) L'invention concerne un procédé permettant de munir une pierre précieuse d'une marque indélibile lisible seulement au microscope et cela par un bombardement cathodique en faisant usage d'un photoresist.

EP 0 064 780 A1

1

"Procédé de traitement d'une pierre précieuse et
pierre précieuse ainsi traitée"

L'invention concerne un procédé de traitement d'une pierre précieuse en vue d'y apporter une inscription sur une de ses faces ou facettes, afin de permettre l'identification de la pierre ainsi traitée.

En raison de leur valeur exceptionnelle, les diamants et de nombreuses autres pierres précieuses doivent pouvoir être identifiées.

Certains laboratoires gemmologiques délivrent des certificats d'authenticité garantissant le degré de pureté, la couleur et d'autres caractéristiques de la pierre. Grâce à ces certificats, l'investissement en diamants et en pierres de couleur a été rendu plus attrayant. Cependant, les pierres ainsi authentifiées doivent, pour jouir de cette garantie, demeurer dans des sachets, tels que des sachets en plastique et, de plus, être conservées dans un coffre, ce qui empêche les propriétaires de ces joyaux de la jouissance des parures dans lesquelles ces pierres ou diamants sont montés. De plus, des fraudes ou des contrefaçons de certificats peuvent se produire, ce qui rend ce système d'identification relativement peu fiable.

Il a, d'autre part, déjà été proposé de munir les pierres elles-mêmes d'une marque d'identification. Une des plus anciennes tentatives de l'espèce est décrite dans le brevet belge 373.939 qui concerne un procédé d'identification de pierres précieuses confiées à un lapidaire en vue d'opérations de finissage. Selon ce procédé, la pierre encore à traiter est revêtue d'une couche solide et adhérente qui la caractérise et dont la présence peut être constatée sur une partie de la pierre jusqu'à la fin des opérations de taille et de polissage.

Des procédés plus récents, visant également l'identification des pierres précieuses, envisagent de créer sur celles-ci, un dépôt en relief de dimensions microscopiques, invisibles à l'oeil nu. L'inconvénient de ces marques d'identification réside évidemment dans le fait qu'elles peuvent disparaître si on les soumet à un polissage ou à une abrasion. De tels procédés ont été décrits par les brevets belges 840.671 et 868.383.

Une autre tentative de solution est préconisée par le brevet belge 877.326 dont la technique de gravure par laser produit des inscriptions de dimensions trop grandes, d'ailleurs lisibles à la loupe et capables, dans ces circonstances, de dévaloriser le diamant dont une des faces ou facettes peut porter une inscription de dimensions insuffisamment réduites.

Enfin, la technique proposée par le brevet belge 878.738 consiste à provoquer, à l'intérieur du diamant lui-même une marque d'identification créée par la transformation irréversible d'une zone déterminée. Ceci revient à provoquer une marque sombre à l'intérieur du diamant, ce qui est parfaitement intolérable.

La présente demande de brevet vise un procédé qui réalise une solution nouvelle et originale et ne présente aucun des inconvénients des techniques détaillées ci-dessus. D'autre part, le procédé permet, sans porter atteinte à la valeur du diamant, de munir celui-ci d'une inscription lisible au microscope et parfaitement indélébile.

A cet effet, conformément à l'invention, on fixe sur la pierre une résine du type "photoresist", on applique sur ladite résine un film photographique portant l'inscription désirée et on développe la résine en exposant celle-ci à une insolation, on élimine de façon connue en soi les parties exposées de ladite résine ainsi que le film précité et on soumet la partie de la pierre ainsi traitée à un bombardement cathodique de telle sorte qu'une gravure de la pierre apparaît aux endroits non protégés par la résine précitée.

Conformément à ce procédé, on procède au bombardement cathodique précité, dans une enceinte sous vide.

Avantageusement, le bombardement cathodique précité est réalisé par introduction d'argon, d'hydrogène, de méthane ou d'un mélange d'hydrogène et d'argon.

Dans une forme de réalisation facultative du procédé selon l'invention, la partie gravée de la pierre est recouverte d'un oxyde métallique.

D'autres détails et avantages de l'invention ressortiront de la description qui sera donnée ci-après d'un procédé de traitement d'une pierre précieuse selon l'invention, cette description n'est donnée qu'à titre d'exemple et ne limite pas l'invention.

Quoique le procédé selon l'invention s'applique aux pierres de grande valeur, donc en premier lieu aux diamants, on peut envisager son application à toute pierre de quelque nature que ce soit. Le mot "pierre" ne doit donc pas être pris dans un sens limitatif quelconque.

Le procédé selon l'invention peut être décrit par les étapes suivantes :

1. Nettoyage de la pierre qui est ensuite séchée de manière parfaite.

Le nettoyage qui a évidemment pour but de garantir une adhérence parfaite de toute matière déposée ultérieurement sur la pierre se fait, par exemple, en laissant séjourner la pierre quelques minutes dans l'alcool éthylique de manière à obtenir une dissolution complète de toute trace organique superficielle. Une agitation réalisée, par exemple, grâce à des ultrasons, peut être prévue. On procède au séchage de la pierre en exposant celle-ci dans un courant d'air chaud pulsé.

2. Dépôt d'une résine du type "photoresist". Une résine convenant parfaitement au but proposé est constituée par un produit mis sur le marché sous la dénomination "AZ-1350" par la firme Shipley. D'autres produits ayant des qualités analogues et utilisés également en tant que photoresist ou photomasque peuvent être utilisés tel que par exemple "KPR" de la firme Kodak.

3. Séchage de la résine de type photoresist et application d'un film photographique dont les parties, d'ailleurs microscopiques, perméables à la lumière représentent un signe ou un caractère correspondant au moyen d'identification de la pierre ou du diamant. L'insolation du photoresist au travers du film photographique est suivie du développement du photoresist.

4. Séchage du photoresist gravé au cours de l'étape précédente, ce qui fait apparaître des creux correspondant aux signes d'identification désirés, en conformité avec les signes d'identification portés par le film photographique cité plus haut. La pierre n'est donc pas protégée aux endroits gravés du photoresist.

5. Installation de la pierre traitée conformément aux étapes décrites ci-dessus, dans une chambre sous vide et gravure ou "etching" par bombardement cathodique à l'aide d'un gaz ionisé.

6. Revêtement facultatif à l'aide d'un oxyde métallique des parties gravées en creux dans la pierre, enlèvement du photoresist, ce qui peut se faire manuellement à l'aide d'un chiffon imbibé d'alcool éthylique ou d'acétone.

Au sujet des opérations détaillées ci-dessus, on peut encore donner les précisions suivantes. Le demandeur a constaté que pour obtenir des profondeurs de gravure suffisantes, et assurer une protection des faces sous-jacentes par un revêtement éventuel à l'aide d'un oxyde métallique, une épaisseur initiale de la résine photoresist de l'ordre de 0,8 μ était nécessaire. Cette épaisseur est sans influence sur la netteté des contours de la gravure finale de la pierre. L'épaisseur de la couche de résine photoresist est réglée grâce au choix de la vitesse de centrifugation qui anime la pierre en vue d'étendre régulièrement la résine. En effet, cette opération, connue en soi, est nécessaire pour étendre régulièrement la résine.

Le séchage de cette résine s'obtient après quelques minutes à une température d'environ 60°, ce qui assure une évaporation complète du solvant de la résine. L'opération d'insolation à l'aide d'une lampe UV au travers du film photographique à contraste accentué appliqué sur la résine exige une exposition de 45 secondes environ, tandis que la source de rayonnement UV est située à une distance variant de 25 à 30 cm. Les parties développées de la résine photoresist, traitée à l'aide d'un produit développant dilué dans l'eau distillée, laissent passer les rayons UV pour donner naissance au signe d'identification désiré. Un rinçage énergique de la résine photoresist doit être prévu après enlèvement du film photographique.

On obtient une résistance maximale du photoresist à l'impact des ions, au cours du processus de bombardement cathodique, grâce à un séchage de la résine "photoresist" d'une durée d'environ 5 minutes.

La gravure de la pierre s'effectue dans une enceinte ou chambre sous vide poussé, de préférence en présence d'argon, dont le plasma permet un arrachement moléculaire superficiel de la pierre à graver. Le gaz d'argon peut être remplacé par de l'hydrogène ou un mélange d'hydrogène et d'argon. Le degré de décapage de gravure de la pierre est cependant moindre dans ces dernièresconditions. On peut également considérer l'utilisation de méthane en lieu et place des gaz ou mélanges de gaz cités ci-dessus. Le bombardement cathodique également connu sous le nom de "etching" provoque une gravure des parties non protégées par la résine photoresist de la pierre soumise au traitement décrit ci-dessus. La profondeur de la gravure peut varier entre 50 et 500 Angströms. Les traits de la gravure réalisée selon le procédé décrit ci-dessus sont invisibles à l'oeil nu attendu qu'on peut admettre que leur épaisseur est de 50 à 500 fois inférieure à celle d'un cheveu, correspondant lui-même à 1/1000e de milimètre. L'identification de l'inscription portée sur la pierre par le bombardement cathodique, dans les conditions décrites ci-dessus, ne nuit donc en rien à la valeur de la pierre et n'altère en rien ses qualités ni son éclat.

Les parties gravées de la pierre peuvent accessoirement être pourvues d'un revêtement à l'aide d'un oxyde métallique.

Les matériaux choisis en vue de ce revêtement des parties gravées doivent présenter des caractéristiques de résistance chimique et d'absence de coloration intrinsèque optimales. Les métaux sont donc à écarter et seuls entrent en ligne de compte les oxydes de certains d'entre eux. Les meilleurs résultats ont été obtenus par le dépôt

8

d'oxyde de titane ($TiO_2$), d'oxyde de plomb (PbO) ou d'oxyde de zirconium ($ZrO_2$). Ces trois oxydes n'épuisent pas la liste des possibilités et n'ont été donnés qu'à titre d'exemple.

Le dépôt d'un oxyde métallique sur les parties gravées de la pierre peut être effectué suivant diverses méthodes. Deux d'entre elles sont données à titre d'exemple ci-dessous :
- pulvérisation réactive à partir d'une cible métallique en présence d'oxygène;
- pulvérisation à haute fréquence à partir d'une cible constituée du matériau dont l'oxyde doit être déposé, et cela par exemple en présence d'argon.

Il est évident qu'on prendra toutes mesures nécessaires pour éviter que l'épaisseur du revêtement ne dépasse la profondeur de la gravure.

Le revêtement d'un oxyde métallique améliore la lisibilité à l'aide d'un microscope. La différence d'indice de réfraction entre les matériaux de la pierre et l'oxyde métallique déposé provoque l'amélioration de la lisibilité au microscope.

A titre d'exemple on notera que l'indice de réfraction du diamant est de 2,417 tandis que celui du dépôt de l'oxyde de titane effectué dans les conditions décrites ci-dessus se situe entre 2,3 et 2,5, ce qui est donc très proche de l'indice du diamant et rend l'inscription parfaitement invisible à l'oeil nu.

De la description du procédé qui vient d'être donnée ci-dessus, on remarquera un certain nombre d'avantages importants qui distinguent le procédé selon l'invention des procédés proposés à ce jour et dont les principaux ont été décrits dans le préambule. Ces avantages sont :

- invisibilité à l'oeil nu de la gravure réalisée;
- absence de modification de la pureté ou de la couleur de la pierre;
- absence de tout danger pour la pierre elle-même;
- aucune altération de l'éclat, de la brillance ni de la diffraction du rayonnement lumineux dans la pierre;
- impossibilité d'effacement, de falsification ni aucun danger de détérioration par l'usage de la pierre montée en bijou par exemple;
- lisibilité au microscope, par un non initié par exemple.

A propos de la lisibilité, il est en effet important de noter que pour des profondeurs d'inscription très faibles, la visibilité sous microscope des caractères ne peut actuellement se faire que par des méthodes utilisant les techniques d'interférométrie ou de contraste de phase avec des liquides d'indice de réfraction se rapprochant de celui du diamant, liquidesdont le caractère toxique n'est pas négligeable.

Ces inconvénients ne s'appliquent pas au procédé selon la demande attendu que la lecture à l'aide d'un simple microscope suffit.

On remarquera enfin que de toute évidence l'inscription en gravure est inaltérable, à moins que la pierre ne subisse un nouveau polissage qui en diminuera évidemment la valeur.

## REVENDICATIONS.

1. Procédé de traitement d'une pierre précieuse en vue d'y porter une inscription sur une de ses faces ou facettes, sur la table ou le rondiste, dans le but de permettre l'identification de la pierre ainsi traitée, caractérisée en ce qu'on fixe sur la pierre une résine du type "photoresist", on applique sur ladite résine un film photographique portant l'inscription précitée et on développe ladite résine en exposant celle-ci à une insolation, on élimine de façon connue en soi les parties exposées de ladite résine et on soumet la partie de la pierre ainsi traitée à un bombardement cathodique, appelé également "etching", de telle sorte qu'une gravure de la pierre apparaît aux endroits non protégés par la résine précitée.

2. Procédé selon la revendication 1, caractérisé en ce qu'on procède au bombardement cathodique précité dans une enceinte sous vide.

3. Procédé selon la revendication 2, caractérisé en ce que le bombardement cathodique précité est réalisé en présence d'argon.

4. Procédé selon la revendication 2, caractérisé en ce que le bombardement cathodique précité est réalisé en présence d'hydrogène.

5. Procédé selon la revendication 2, caractérisé en ce que le bombardement cathodique précité est réalisé en présence de méthane.

6. Procédé selon la revendication 2, caractérisé en ce que le bombardement cathodique précité est réalisé en présence d'hydrogène et d'argon.

7. Procédé selon l'une quelconque des revendications 1 à 6, caractérisé en ce que la gravure obtenue par arrachement moléculaire de la matière au cours du bombardement cathodique précité est revêtue par un oxyde métallique dont l'épaisseur ne dépasse pas celle de la gravure précitée.

8. Procédé selon la revendication 7, caractérisé en ce que l'oxyde métallique est un oxyde de titane ($TiO_2$).

9. Procédé selon la revendication 7, caractérisé en ce que l'oxyde métallique est un oxyde de plomb (Pb O).

10. Procédé selon la revendication 7, caractérisé en ce que l'oxyde métallique est un oxyde de zirconium ($ZrO_2$).

11. Procédé selon l'une quelconque des revendications 7 à 10, caractérisé en ce que le revêtement à l'aide d'un oxyde métallique est réalisé par bombardement ionique d'une cible du métal pur correspondant en présence d'un gaz oxydant.

12. Pierre précieuse portant une inscription réalisée conformément au procédé selon l'une quelconque des revendications 1 à 11.

# 0064780

## DOCUMENTS CONSIDERES COMME PERTINENTS

| Categorie | Citation du document avec indication. en cas de besoin. des parties pertinentes | Revendication concernee | CLASSEMENT DE LA DEMANDE (Int. Cl ³) |
|---|---|---|---|
| X,Y D | BE-A- 868 383 (K. OKUDA) <br><br> * page 5, ligne 14 - page 7, ligne 8; page 8, lignes 16-24; revendications 1,3,4 * <br><br> --- | 1-12 | A 44 C 17/00 <br> G 03 F 7/26 // <br> C 23 C 14/04 <br> C 23 C 14/00 <br> C 30 B 33/00 |
| Y | FR-A-2 004 645 (MATSUSHITA ELECTRIC INDUSTRIAL) <br> * revendications 1,2 * <br><br> --- | 1,7-12 | |
| A | FR-A-1 476 536 (GENERAL ELECTRIC) <br><br> --- | | |
| A | FR-A-1 481 918 (GENERAL ELECTRIC) <br><br> --- | | |
| A | US-A-3 945 902 (F.Z. HAWRYLO et al.) <br><br> ----- | | |

DOMAINES TECHNIQUES
RECHERCHES (Int. Cl. ³)

A 44 C 17/00
G 03 F 7/00
C 23 C 14/00
C 30 B 33/00

Le present rapport de recherche a ete etabli pour toutes les revendications

| Lieu de la recherche | Date d achevement de la recherche | Examinateur |
|---|---|---|
| LA HAYE | 26-07-1982 | PHILOSOPH L.P. |